# EUROPEAN PATENT SPECIFICATION

(11) **EP 4 361 653 B1**
(45) Date of publication and mention of the grant of the patent: **19.08.2026**
(21) Application number: 23749908.2
(22) Date of filing: 05.01.2023
(51) Int. Cl.: G01R 31/367, G01R 31/396, G01R 31/392, G01R 31/382, H02J 7/00

(54) **DEVICE AND METHOD FOR MANAGING BATTERY**
VORRICHTUNG UND VERFAHREN ZUR VERWALTUNG EINER BATTERIE
DISPOSITIF ET PROCÉDÉ PERMETTANT DE GÉRER UNE BATTERIE

(30) Priority: 03.02.2022 KR 20220013910
(43) Date of publication of application: 01.05.2024
(73) Proprietor: LG Energy Solution, Ltd., Seoul 07335 (KR)
(72) Inventor: KIM, Songgwon, Daejeon 34122 (KR)
(74) Representative: Plasseraud IP
(86) International application number: PCT/KR2023/000210
(87) International publication number: WO 2023/149673

(56) References cited:
- EP-A1- 3 678 272
- EP-A1- 3 916 943
- KR-A- 20120 017 930
- KR-A- 20170 052 028
- KR-A- 20180 026 947
- KR-A- 20200 003 633
- US-A1- 2009 146 610

## Description

### [Technical Field]

This application claims priority to and the benefit of Korean Patent Application No.10-2022-0013910 filed in the Korean Intellectual Property Office on February 03, 2022.

The present invention relates to an apparatus and a method for managing a battery, and more particularly, to an apparatus and a method for managing a battery capable of continuously monitoring states of a battery with an abnormality using a normally charged battery module voltage even when a charge/discharge circuit is blocked for battery protection due to an abnormality of the battery cell.

### [Background Art]

Batteries are being applied to various industrial fields such as mobile application devices, automobiles, robots, and energy storage devices as a countermeasure against environmental regulations and high oil price issues.

In general, a battery is provided as a rechargeable secondary battery, but such a battery is ignited when overcharged or deteriorated when overdischarged, resulting in a reduced lifespan.

Accordingly, a conventional battery management apparatus provides a battery protection circuit that blocks a charging/discharging circuit when an abnormality occurs in a battery cell in order to protect the battery. For example, the battery protection circuit blocks a charging/discharging circuit by controlling operations of a switch connected to a plurality of battery cells.

Meanwhile, the battery management apparatus may receive a driving voltage through a battery protection circuit. Accordingly, when an abnormality occurs in one battery cell and the charging/discharging circuit is blocked, the operation of the battery management apparatus is stopped, and thus, battery diagnosis and monitoring functions cannot be performed, either. Therefore, the battery management apparatus cannot secure state data of the battery in which the abnormality has occurred, the reliability of abnormal battery analysis may be lowered since little data is available for analysis, and it is difficult to detect any change in a state of the battery until the battery is inspected or retrieved.

In addition, when an error occurs in any one battery cell in the battery pack, the battery management for normally operating battery cells is also stopped, thereby lowering efficiency.

Embodiments and examples from prior art are presented in the documents EP 3 916 943 A1 and EP 3 678 272 Al.

### [Detailed Description of the Invention]

### [Technical Problem]

To obviate one or more problems of the related art, embodiments according to an object of the present disclosure provide a battery management apparatus with high efficiency, low cost and high reliability.

To obviate one or more problems of the related art, embodiments according to another object of the present disclosure provide a battery management method with high efficiency, low cost and high reliability.

### [Technical Solution]

In order to achieve the objective of the present disclosure, a battery management apparatus is defined in claim 1.

According to another embodiment of the present disclosure, a battery management method according to claim 6 is also provided.

### [Brief Description of the Drawings]

FIG. 1 is a block diagram of a general battery system.
FIG. 2 is a block diagram of a battery system according to embodiments of the present invention.
FIG. 3 is a block diagram of a battery management apparatus according to embodiments of the present invention.
FIG. 4 is a flowchart of a battery management method according to embodiments of the present invention.

1000: battery 3000: battery protection device
5000: battery power source control device 7000: battery management apparatus
100: memory

### [Best Mode]

The present invention may be modified in various forms and have various embodiments, and specific embodiments thereof are shown by way of example in the drawings and will be described in detail below. It should be understood, however, that there is no intent to limit the present invention to the specific embodiments. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

Terms used in the present application are used only to describe specific embodiments, and are not intended to limit the present invention. A singular form includes a plural form if there is no clearly opposite meaning in the context. In the present application, it should be understood that the term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

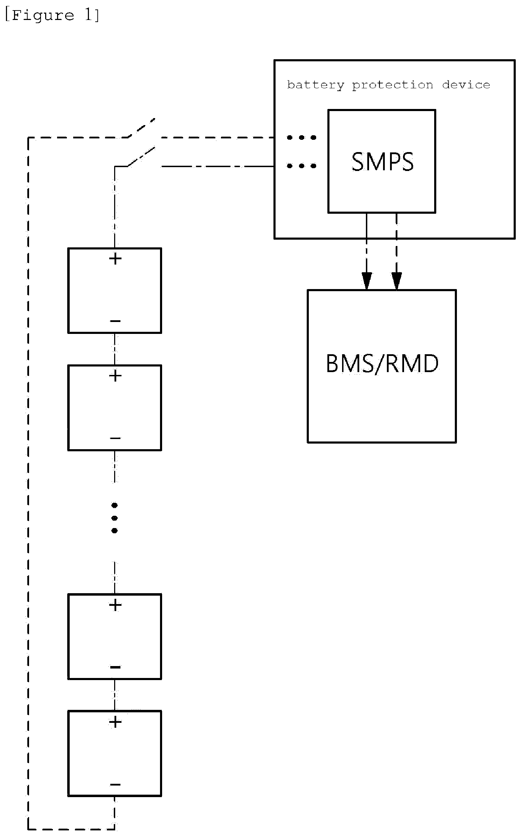

FIG. 1 is a block diagram of a typical battery system.

Referring to FIG. 1, a battery pack or battery module may include a plurality of battery cells connected in series. The battery pack or module may be connected to a load through a positive terminal and a negative terminal to perform a charge/discharge operation. The most commonly used battery cell is a lithium-ion (Li-Ion) battery cell.

Such a battery pack or battery module may interwork with a battery management system (BMS) through a battery protection device.

A battery management system (BMS) may monitor a current, a voltage, and a temperature of each battery cell or module under its control, calculate a status of charge (SOC) based on the monitoring results, and control charging and discharging. Here, State of Charge (SOC) refers to a current state of charge of a battery, represented in percent points [%], and State of Health (SOH) may be a current condition of a battery compared to its ideal or original conditions, represented in percent points [%].

As such, the battery management system (BMS) monitors battery cells and can read cell voltages and transmit them to another system connected to the battery. For this, the battery management system (BMS) may include a communication module for communicating with other systems in a device including the battery system.

The communication module of the battery management system (BMS) may communicate with other systems within the device using a Controller Area Network (CAN). Here, parts, modules, or systems within the battery management system (BMS) are connected to each other through a CAN bus. Accordingly, the battery management system (BMS) may remotely transmit state data acquired through monitoring of the battery pack or module to another system using CAN communication.

Meanwhile, the battery management system (BMS) may equally balance charges of the battery cells in order to extend a life of the battery system.

To perform such an operation, a battery management system (BMS) may include various components such as a fuse, a current sensing element, a thermistor, a switch, and a balancer, and may further include a micro controller unit (MCU) or a battery monitoring integrated chip (BMIC) to interconnect with and control the components in the BMS in most cases. Here, the BMIC may be an IC-type component that is located inside a battery management system (BMS) and measure information such as voltage, temperature, and current of a battery cell/module.

In general, the battery management system (BMS) is interlocked with a battery protection device, and when an abnormality occurs in the battery, the battery protection device blocks the charge/discharge circuit. In other words, when an abnormality occurs in any one battery cell or module, a general battery protection circuit cuts off the charge/discharge circuit to limit use of the battery.

Meanwhile, a general battery management apparatus may receive power from a battery-powered battery module by being connected to a switched mode power supply (SMPS) in a battery protection device without a separate external power supply line.

However, since the power supply device (SMPS) receives power through the charge/discharge circuit, power is not supplied to the battery management system (BMS) when the charge/discharge circuit is blocked, and thus, diagnosis and monitoring functions of the battery is also stopped in case of a battery abnormality occurrence.

Accordingly, as the power supply to a device for remote transmission is also cut off in a general battery management system, it is difficult to remotely transmit battery state data accumulated through monitoring, thereby leading to a disadvantage that the securing of state data for the analysis of the battery in which an abnormality occurred was limited.

Accordingly, the present invention provides a battery management apparatus capable of obtaining state data for analysis by continuously diagnosing and monitoring an abnormal battery by receiving power from a battery having no abnormality when a battery abnormality occurs, which will be described in the following.

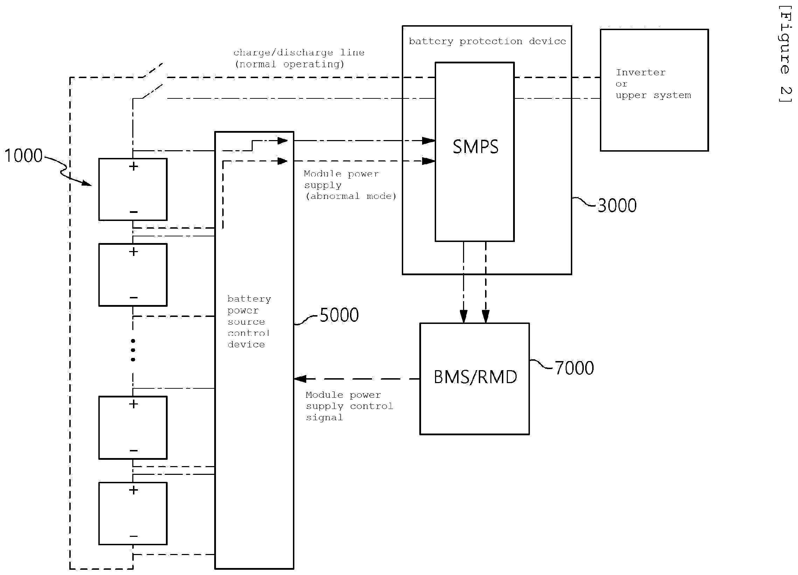

FIG. 2 is a block diagram of a battery system according to embodiments of the present invention.

Referring to FIG. 2, the battery system may include a battery module 1000, a battery protection device 3000, a battery power source control device 5000, and a battery management apparatus 7000.

The battery module 1000 may include a plurality of battery cells connected in series or parallel. Here, a generally used battery cell may be a lithium ion (Li-Ion) battery cell.

The battery module 1000 may be connected to a load through a positive terminal and a negative terminal to perform charging and discharging operations. For example, the load may be an inverter or an upper system.

The battery protection device 3000 may be connected to any one battery module through a charge/discharge circuit and a battery power source control device 5000 to be described later.

In addition, the battery protection device 3000 may be connected to a battery management apparatus (BMS) 7000 to be described later. Accordingly, the battery management apparatus 7000 may receive a driving voltage from any one of a charging/discharging circuit or a power supply module connected to the battery power source control device 5000 through the battery protection device 3000.

Meanwhile, the battery protection device 3000 may protect at least one battery module 1000 by blocking the charging/discharging circuit under the control of the battery management apparatus 7000 when an abnormality occurs in any one of the battery cells.

The battery power source control device 5000 may include a plurality of switches individually connected to the battery modules 1000. More specifically, the front ends of the switches in the battery power source control device 5000 may be connected to respective battery modules 1000 and the rear ends may be connected to the switched mode power supply (SMPS) in the battery protection device 3000.

Meanwhile, the battery power source control device 5000 may individually control operations of a plurality of switches by a control signal of the battery management apparatus 7000 to be described later. Here, the plurality of switches may be initialized as an OPEN state.

According to embodiments, the battery power source control device 5000 may control operations of a specific switch connected to one of the battery modules 1000 when the battery management apparatus 7000 operates in a monitoring mode, so that power supplied from the battery module 1000 may be transferred to the battery management apparatus 7000 through the power supply unit (SMPS) in the battery protection device 3000. Here, the battery module 1000 may be a power supply module.

As described above, the battery management apparatus 7000 may diagnose and monitor states of the battery 1000. Accordingly, the battery management apparatus 7000 may detect whether an abnormality has occurred in at least one battery cell in the battery modules 1000.

The battery management apparatus 7000 may operate in a management mode or a monitoring mode according to whether any one battery cell has an abnormality.

According to an embodiment, when the battery management apparatus 7000 operates in a management mode, the battery management apparatus 7000 may continuously diagnose and monitor states of at least one battery cell.

In addition, the battery management apparatus 7000 may remotely transmit state data of the at least one battery cell acquired through monitoring to an external device. Accordingly, a user can perform state analysis on the battery cells.

Meanwhile, the battery management apparatus 7000 may switch the operation mode to a monitoring mode when an abnormality occurs in any one battery cell. Thereafter, the battery management apparatus 7000 may transmit a switch control signal to the battery protection device 3000 to control the battery protection device 3000 to cut off the charge/discharge circuit.

Furthermore, when the battery management apparatus 7000 operates in a monitoring mode, the battery management apparatus 7000 may transmit a control signal for a switch connected to the power supply module, to the battery power source control device 5000. Accordingly, the battery power source control device 5000 may control the switch connected to the power supply module to be in a closed state so that a driving voltage applied from the power supply module may be transferred to the battery management apparatus 7000 through the battery protection device 3000.

Therefore, the battery management apparatus 7000 receives power from the power supply module and continuously monitors the battery, thereby obtaining continuous state data on the battery in which the abnormality has occurred, and remotely transmitting the data to an external device to precisely determine the abnormality. It may be possible to analyze the state of the battery.

Meanwhile, the battery management apparatus 7000 is not limited to the disclosed one and may be provided as a remote monitoring device (MCD).

The remote monitoring device (RMD) may be a device that transmits at least one piece of information about a battery cell or module to an online storage space.

According to an embodiment, the remote monitoring device (RMD) may be applied to an energy storage system (ESS) and store information of at least one ESS battery module in an online server.

For example, the remote monitoring device (RMD) may collect state and operation information of at least one battery, such as an installation country, a region, a serial number, and an installation time of an ESS battery, and diagnostic information of the ESS battery for a certain period of time. Thereafter, the remote monitoring device (RMD) may transmit at least one piece of battery information to at least one cloud server connected through online.

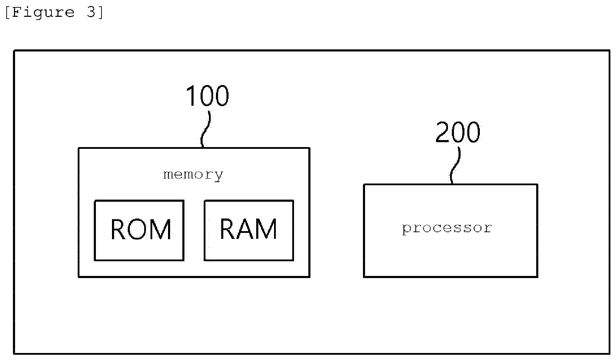

The battery management apparatus 7000 will be described in more detail in FIG. 3 below.

FIG. 3 is a block diagram of a battery management apparatus according to embodiments of the present invention.

Referring to FIG. 3, a battery management apparatus 7000 may include a memory 100 and a processor 200.

In more detail according to embodiments, the memory 100 is a space for storing at least one piece of data and may include at least one of a volatile storage medium and a non-volatile storage medium. For example, the memory 100 may include at least one of a read only memory (ROM) and a random access memory (RAM).

Here, the memory 100 may include at least one command executed by the processor 200.

According to embodiments, the at least one instruction may include an instruction to monitor a plurality of battery cells included in the one or more battery modules; an instruction to, in the instance that an abnormality occurs in the one or more battery cells among the plurality of battery cells, select one of the battery modules, except the battery module including the battery cell in which the abnormality occurred, as a power supply module; an instruction to transmit a control signal to a battery power source control device connected to the plurality of battery modules to connect a selected power supply module and the battery protection device; and an instruction to receive power from the battery protection device connected to the power supply module and to obtain state data of the battery cell in which the abnormality occurred.

The processor 200 may be a central processing unit (CPU), a graphics processing unit (GPU), or a dedicated processor on which methods according to embodiments of the present invention are performed.

As described above, the processor 200 may repeatedly execute at least one program command stored in the memory 100.

In the above, the battery management apparatus according to embodiments of the present invention has been described. Hereinafter, a battery management method according to operations of a processor of a battery management apparatus will be described in detail.

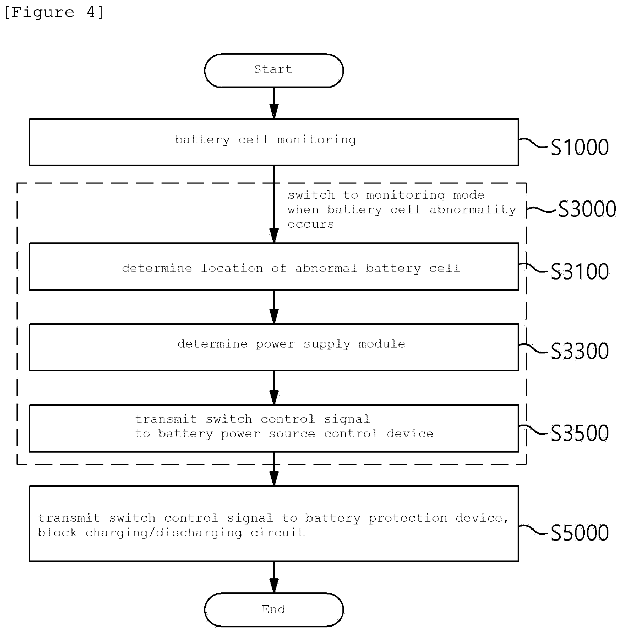

FIG. 4 is a flowchart of a battery management method according to embodiments of the present invention.

Referring to FIG. 4, the processor 200 in the battery management apparatus 7000 may operate in a management mode and monitor whether an abnormality occurs in at least one cell in the plurality of battery modules 1000 (S1000).

According to an embodiment, the processor 200 may individually monitor currents, voltages, and temperatures of the battery cells to measure state data, and, in the instance that at least one state data is equal to or greater than a threshold value, the processor 200 may determine that an abnormality has occurred in a battery cell corresponding to the state data.

Thereafter, the processor 200 may switch the operating mode of the battery management apparatus 7000 from the management mode to a monitoring mode when an abnormality occurs in any one battery cell (S3000). Accordingly, the processor 200 may control the battery power source control device 5000 to receive power for monitoring state of the battery 1000 from a battery module (power supply module).

In more detail according to embodiments, the processor 200 may diagnose the battery cell and determine a location of the battery cell where the abnormality occurs (S3100).

Thereafter, the processor 200 may select one power supply module among the plurality of battery modules 1000 to receive a driving voltage (S3300). Here, the power supply module is a battery module which is located farthest from the battery cell in which the abnormality has occurred.

Here, when there are a plurality of battery modules farthest from the battery cell in which the abnormality has occurred, the processor 200 may compare charge rates (SOC) or states of health (SOH) of the battery modules located in a same distance and select a battery module having a larger SOC value or a smaller SOH value as a power supply module. Here, the charge rate (SOC) of the battery module may refer to a current state of charge of a battery, represented in percent points [%], and the state of health (SOH) of the battery module may be a current condition of a battery compared to its ideal or original conditions, represented in percent points [%].

Meanwhile, when battery modules having the same SOC value or SOH value exist, the processor 200 may select a battery module connected closer to the negative terminal of the battery modules among the plurality of battery modules 1000 as the power supply module.

Thereafter, the processor 200 may transmit a switch control signal to the battery power source control device 5000 to control the switch connected to the power supply module to a closed state (S3500).

The processor 200 may operate the battery protection device 3000 to block a charging/discharging circuit of the battery (S5000). However, it is not limited to what has been described, and steps S3000 and S5000 may be performed simultaneously.

Meanwhile, the processor 200 may transmit a control signal to the battery power source control device 5000 when the SOC of the power supply module falls below a threshold value during operation in the monitoring mode, and may control a specific switch in the battery power source control device 5000 connected to the power supply module to be in an open state.

Thereafter, the processor 200 may re-execute step S3300 to re-select another battery module having a charge rate equal to or higher than the threshold among battery modules, excluding the battery module including the battery cell in which the abnormality occurred, as a power supply module, and receive power from the power supply module to continuously perform battery state monitoring.

The battery management apparatus and a method according to embodiments of the present invention have been described above.

According to embodiments of the present invention, a battery management apparatus and method for performing battery condition monitoring in conjunction with a battery protection device connected to one or more battery modules, may monitor a plurality of battery cells included in the one or more battery modules; upon an abnormality occuring in the one or more battery cells among the plurality of battery cells, select one of the battery modules, except the battery module including the battery cell in which the abnormality occurred, as a power supply module; transmit a control signal to a battery power source control device connected to the plurality of battery modules to connect a selected power supply module and the battery protection device; and receive power from the battery protection device connected to the power supply module and obtaining state data of the battery cell in which the abnormality occurred, and thus, it is possible to continuously monitor states of the battery with abnormality using a voltage of a normally charged battery even when a charge/discharge circuit is blocked for battery protection, thereby providing a battery management apparatus and method with high efficiency, low cost and high reliability capable of obtaining status data for analysis of abnormal batteries without having a separate power supply line from the outside.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer readable medium may include a hardware device such as ROM, RAM, and flash memory, which are specifically configured to store and execute the program instructions. Examples of the program instructions include machine codes made by, for example, a compiler, as well as high-level language codes executable by a computer, using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

## Claims

1. A battery management apparatus (7000) wherein the battery management apparatus is configured tc perform battery condition monitoring in conjunction with a battery protection device (3000) connected to one or more battery modules, the battery management apparatus (7000) comprising:
at least one processor (200); and
a memory (100) configured to store at least one instruction executed by the at least one processor (200),
wherein the at least one instruction includes:
an instruction to monitor a plurality of battery cells included in the one or more battery modules (1000);
an instruction to, in the instance that an abnormality occurs in the one or more battery cells among the plurality of battery cells, select one of the battery modules, except the battery module including the battery cell in which the abnormality occurred, as a power supply module;
an instruction to transmit a control signal to a battery power source control device (5000) connected to the plurality of battery modules to connect the selected power supply module and the battery protection device (3000); and
an instruction to receive power from the battery protection device (3000) connected to the power supply module and to obtain state data of the battery cell in which the abnormality occurred;
**characterized in that** the instruction to select one of the battery modules as a power supply module includes:
an instruction to determine a location of the battery cell in which the abnormality occurred; and
an instruction to select a battery module farthest from the battery module including the battery cell in which the abnormality has occurred, as the power supply module.

2. The battery management apparatus of claim 1, wherein the instruction to select a battery module farthest from the battery module including the battery cell in which the abnormality has occurred as the power supply module includes an instruction to, in the instance that there exists a plurality of battery modules farthest from the battery cell in which the abnormality occurred, compare states of charge (SOC) or lifespans (State of Health: SOH) of the battery modules to select a power supply module.

3. The battery management apparatus of claim 2, wherein the instruction to select the battery module farthest from the battery module including the battery cell in which the abnormality occurred as the power supply module includes an instruction to, in the instance that at least one of the SOC or SOH values of the battery modules is the same, select a battery module connected closer to a negative terminal of the battery modules as the power supply module.

4. The battery management apparatus of claim 1, wherein the battery power source control device is configured to:
receive the control signal from the battery management apparatus (7000); and
connect the power supply module and the battery protection device (3000) by closing a switch corresponding to the selected power supply module among a plurality of switches in the battery power source control device.

5. The battery management apparatus of claim 4, wherein the at least one instruction further includes an instruction to, upon a charge voltage of the power supply module dropping below a threshold value, reselect a battery module having a charge rate equal to or higher than a threshold value as the power supply module among battery modules excluding the battery module including the battery cell in which the abnormality occurred.

6. A battery management method for performing battery condition monitoring in conjunction with a battery protection device (3000) connected to one or more battery modules (1000), wherein the battery management method comprises:
monitoring (S1000) a plurality of battery cells included in the one or more battery modules (1000);
upon an abnormality occurring in the one or more battery cells among the plurality of battery cells, selecting (S3300) one of the battery modules, except the battery module including the battery cell in which the abnormality occurred, as a power supply module;
transmitting (S3500) a control signal to a battery power source control device connected to the plurality of battery modules to connect the selected power supply module and the battery protection device (3000); and
receiving power from the battery protection device connected to the power supply module and obtaining state data of the battery cell in which the abnormality occurred;
**characterized in that** selecting (S3300) one of the battery modules as the power supply module includes:
determining a location of the battery cell in which the abnormality occurred; and
selecting a battery module farthest from the battery module including the battery cell in which the abnormality has occurred, as the power supply module.

7. The method of claim 6, wherein the selecting the battery module farthest from the battery module including the battery cell in which the abnormality occurred as the power supply module includes, in the instance that there exist a plurality of battery modules farthest from the battery cell in which the abnormality occurred, comparing states of charge (SOC) or lifespans (State of Health, SOH) of the battery modules to select the power supply module.

8. The method of claim 6, wherein the selecting the battery module farthest from the battery module including the battery cell in which the abnormality occurred as the power supply module includes, in the instance that at least one of the SOC or SOH values of the battery modules is the same, selecting a battery module connected closer to a negative terminal of the battery modules as the power supply module.

9. The method of claim 6, wherein the battery power source control device is configured to:
receive the control signal from the battery management apparatus (7000); and
connect the power supply module and the battery protection device (3000) by closing a switch corresponding to the selected power supply module among a plurality of switches in the battery power source control device.

10. The method of claim 9, further comprising, upon a charge voltage of the power supply module dropping below a threshold value, reselecting a battery module having a charge rate equal to or higher than a threshold value as the power supply module among battery modules excluding the battery module including the battery cell in which the abnormality occurred.

## Patentansprüche

1. Batteriemanagementvorrichtung (7000), wobei die Batteriemanagementvorrichtung so konfiguriert ist, dass sie eine Überwachung des Batteriezustands in Verbindung mit einer Batterieschutzvorrichtung (3000) durchführt, die mit einem oder mehreren Batteriemodulen verbunden ist, wobei die Batteriemanagementvorrichtung (7000) Folgendes umfasst:
mindestens einen Prozessor (200); und
einen Speicher (100), der so konfiguriert ist, dass er mindestens einen Befehl speichert, der von dem mindestens einen Prozessor (200) ausgeführt wird,
wobei der mindestens eine Befehl Folgendes enthält:
einen Befehl zum Überwachen einer Vielzahl von Batteriezellen, die in dem einen oder den mehreren Batteriemodulen (1000) enthalten sind;
einen Befehl, um in dem Fall, dass eine Anomalie in der einen oder den mehreren Batteriezellen unter der Vielzahl von Batteriezellen auftritt, eines der Batteriemodule, mit Ausnahme des Batteriemoduls, das die Batteriezelle enthält, in der die Anomalie aufgetreten ist, als Stromversorgungsmodul auszuwählen;
einen Befehl zum Übertragen eines Steuersignals an eine Batteriestromquellen-Steuervorrichtung (5000), die mit der Vielzahl von Batteriemodulen verbunden ist, um das ausgewählte Stromversorgungsmodul und die Batterieschutzvorrichtung (3000) zu verbinden; und
einen Befehl zum Empfangen von Strom von der Batterieschutzvorrichtung (3000), die mit dem Stromversorgungsmodul verbunden ist, und zum Erhalten von Zustandsdaten der Batteriezelle, in der die Anomalie aufgetreten ist;
**dadurch gekennzeichnet, dass** der Befehl zum Auswählen eines der Batteriemodule als Stromversorgungsmodul Folgendes enthält:
einen Befehl zum Bestimmen einer Position der Batteriezelle, in der die Anomalie aufgetreten ist; und
einen Befehl zum Auswählen eines Batteriemoduls, das am weitesten von dem Batteriemodul entfernt ist, das die Batteriezelle enthält, in der die Anomalie aufgetreten ist, als Stromversorgungsmodul.

2. Batteriemanagementvorrichtung nach Anspruch 1, wobei der Befehl zum Auswählen eines Batteriemoduls, das am weitesten von dem Batteriemodul entfernt ist, das die Batteriezelle enthält, in der die Anomalie aufgetreten ist, als Stromversorgungsmodul einen Befehl umfasst, um in dem Fall, dass eine Vielzahl von Batteriemodulen existiert, die am weitesten von der Batteriezelle entfernt sind, in der die Anomalie aufgetreten ist, Ladezustände (SOC) oder Lebensdauern (Gesundheitszustand: SOH) der Batteriemodule zu vergleichen, um ein Stromversorgungsmodul auszuwählen.

3. Batteriemanagementvorrichtung nach Anspruch 2, wobei der Befehl zum Auswählen des Batteriemoduls, das am weitesten von dem Batteriemodul entfernt ist, das die Batteriezelle enthält, in der die Anomalie aufgetreten ist, als Stromversorgungsmodul einen Befehl umfasst, um in dem Fall, dass mindestens einer der SOC- oder SOH-Werte der Batteriemodule gleich ist, ein Batteriemodul, das näher an einem negativen Anschluss der Batteriemodule angeschlossen ist, als Stromversorgungsmodul auszuwählen.

4. Batteriemanagementvorrichtung nach Anspruch 1, wobei die Batteriestromquellen-Steuervorrichtung so konfiguriert ist, dass sie:
das Steuersignal von der Batteriemanagementvorrichtung (7000) empfängt; und
das Stromversorgungsmodul und die Batterieschutzvorrichtung (3000) durch Schließen eines Schalters verbindet, der dem ausgewählten Stromversorgungsmodul unter einer Vielzahl von Schaltern in der Batteriestromquellen-Steuervorrichtung entspricht.

5. Batteriemanagementvorrichtung nach Anspruch 4, wobei der mindestens eine Befehl ferner einen Befehl enthält, um beim Abfallen einer Ladespannung des Stromversorgungsmoduls unter einen Schwellenwert ein Batteriemodul mit einer Laderate, die gleich oder höher als ein Schwellenwert ist, als Stromversorgungsmodul unter den Batteriemodulen, mit Ausnahme des Batteriemoduls, das die Batteriezelle enthält, in der die Anomalie aufgetreten ist, erneut auszuwählen.

6. Batteriemanagementverfahren zum Durchführen einer Überwachung des Batteriezustands in Verbindung mit einer Batterieschutzvorrichtung (3000), die mit einem oder mehreren Batteriemodulen (1000) verbunden ist, wobei das Batteriemanagementverfahren Folgendes umfasst:
Überwachen (S1000) einer Vielzahl von Batteriezellen, die in dem einen oder den mehreren Batteriemodulen (1000) enthalten sind;
beim Auftreten einer Anomalie in der einen oder den mehreren Batteriezellen unter der Vielzahl von Batteriezellen, Auswählen (S3300) eines der Batteriemodule, mit Ausnahme des Batteriemoduls, das die Batteriezelle enthält, in der die Anomalie aufgetreten ist, als Stromversorgungsmodul;
Übertragen (S3500) eines Steuersignals an eine Batteriestromquellen-Steuervorrichtung, die mit der Vielzahl von Batteriemodulen verbunden ist, um das ausgewählte Stromversorgungsmodul und die Batterieschutzvorrichtung (3000) zu verbinden; und
Empfangen von Strom von der Batterieschutzvorrichtung, die mit dem Stromversorgungsmodul verbunden ist, und Erhalten von Zustandsdaten der Batteriezelle, in der die Anomalie aufgetreten ist;
**dadurch gekennzeichnet, dass** das Auswählen (S3300) eines der Batteriemodule als Stromversorgungsmodul Folgendes enthält:
Bestimmen einer Position der Batteriezelle, in der die Anomalie aufgetreten ist; und
Auswählen eines Batteriemoduls, das am weitesten von dem Batteriemodul entfernt ist, das die Batteriezelle enthält, in der die Anomalie aufgetreten ist, als Stromversorgungsmodul.

7. Verfahren nach Anspruch 6, wobei das Auswählen des Batteriemoduls, das am weitesten von dem Batteriemodul entfernt ist, das die Batteriezelle enthält, in der die Anomalie aufgetreten ist, als Stromversorgungsmodul in dem Fall, dass eine Vielzahl von Batteriemodulen existiert, die am weitesten von der Batteriezelle entfernt sind, in der die Anomalie aufgetreten ist, das Vergleichen von Ladezuständen (SOC) oder Lebensdauern (Gesundheitszustand, SOH) der Batteriemodule enthält, um das Stromversorgungsmodul auszuwählen.

8. Verfahren nach Anspruch 6, wobei das Auswählen des Batteriemoduls, das am weitesten von dem Batteriemodul entfernt ist, das die Batteriezelle enthält, in der die Anomalie aufgetreten ist, als Stromversorgungsmodul in dem Fall, dass mindestens einer der SOC- oder SOH-Werte der Batteriemodule gleich ist, das Auswählen eines Batteriemoduls, das näher an einem negativen Anschluss der Batteriemodule angeschlossen ist, als Stromversorgungsmodul enthält.

9. Verfahren nach Anspruch 6, wobei die Batteriestromquellen-Steuervorrichtung so konfiguriert ist, dass sie:
das Steuersignal von der Batteriemanagementvorrichtung (7000) empfängt; und
das Stromversorgungsmodul und die Batterieschutzvorrichtung (3000) durch Schließen eines Schalters verbindet, der dem ausgewählten Stromversorgungsmodul unter einer Vielzahl von Schaltern in der Batteriestromquellen-Steuervorrichtung entspricht.

10. Verfahren nach Anspruch 9, ferner umfassend, beim Abfallen einer Ladespannung des Stromversorgungsmoduls unter einen Schwellenwert, das erneute Auswählen eines Batteriemoduls mit einer Laderate, die gleich oder höher als ein Schwellenwert ist, als Stromversorgungsmodul unter den Batteriemodulen, mit Ausnahme des Batteriemoduls, das die Batteriezelle enthält, in der die Anomalie aufgetreten ist.

## Revendications

1. Un appareil de gestion de batterie (7000), dans lequel l'appareil de gestion de batterie est configuré pour effectuer une surveillance de l'état de la batterie en conjonction avec un dispositif de protection de batterie (3000) connecté à un ou plusieurs modules de batterie, l'appareil de gestion de batterie (7000) comprenant :
au moins un processeur (200) ; et
une mémoire (100) configurée pour stocker au moins une instruction exécutée par le au moins un processeur (200),
dans lequel l'au moins une instruction inclut :
une instruction pour surveiller une pluralité de cellules de batterie incluses dans le ou plusieurs modules de batterie (1000) ;
une instruction pour, dans le cas où une anomalie se produit dans l'une ou plusieurs cellules de batterie parmi la pluralité de cellules de batterie, sélectionner un des modules de batterie, à l'exception du module de batterie incluant la cellule de batterie dans laquelle l'anomalie s'est produite, en tant que module d'alimentation ;
une instruction pour transmettre un signal de commande à un dispositif de commande de source d'alimentation de batterie (5000) connecté à la pluralité de modules de batterie pour connecter le module d'alimentation sélectionné et le dispositif de protection de batterie (3000) ; et
une instruction pour recevoir de l'énergie du dispositif de protection de batterie (3000) connecté au module d'alimentation et pour obtenir des données d'état de la cellule de batterie dans laquelle l'anomalie s'est produite ;
**caractérisé en ce que** l'instruction pour sélectionner un des modules de batterie en tant que module d'alimentation inclut :
une instruction pour déterminer un emplacement de la cellule de batterie dans laquelle l'anomalie s'est produite ; et
une instruction pour sélectionner un module de batterie le plus éloigné du module de batterie incluant la cellule de batterie dans laquelle l'anomalie s'est produite, en tant que module d'alimentation.

2. L'appareil de gestion de batterie selon la revendication 1, dans lequel l'instruction pour sélectionner un module de batterie le plus éloigné du module de batterie incluant la cellule de batterie dans laquelle l'anomalie s'est produite en tant que module d'alimentation inclut une instruction pour, dans le cas où il existe une pluralité de modules de batterie les plus éloignés de la cellule de batterie dans laquelle l'anomalie s'est produite, comparer les états de charge (SOC) ou les durées de vie (état de santé : SOH) des modules de batterie pour sélectionner un module d'alimentation.

3. L'appareil de gestion de batterie selon la revendication 2, dans lequel l'instruction pour sélectionner le module de batterie le plus éloigné du module de batterie incluant la cellule de batterie dans laquelle l'anomalie s'est produite en tant que module d'alimentation inclut une instruction pour, dans le cas où au moins une des valeurs de SOC ou de SOH des modules de batterie est la même, sélectionner un module de batterie connecté plus proche d'une borne négative des modules de batterie en tant que module d'alimentation.

4. L'appareil de gestion de batterie selon la revendication 1, dans lequel le dispositif de commande de source d'alimentation de batterie est configuré pour :
recevoir le signal de commande de l'appareil de gestion de batterie (7000) ; et
connecter le module d'alimentation et le dispositif de protection de batterie (3000) en fermant un commutateur correspondant au module d'alimentation sélectionné parmi une pluralité de commutateurs dans le dispositif de commande de source d'alimentation de batterie.

5. L'appareil de gestion de batterie selon la revendication 4, dans lequel l'au moins une instruction inclut en outre une instruction pour, lorsqu'une tension de charge du module d'alimentation chute en dessous d'une valeur de seuil, resélectionner un module de batterie ayant un taux de charge égal ou supérieur à une valeur de seuil en tant que module d'alimentation parmi les modules de batterie excluant le module de batterie incluant la cellule de batterie dans laquelle l'anomalie s'est produite.

6. Un procédé de gestion de batterie pour effectuer une surveillance de l'état de la batterie en conjonction avec un dispositif de protection de batterie (3000) connecté à un ou plusieurs modules de batterie (1000), dans lequel le procédé de gestion de batterie comprend :
la surveillance (S1000) d'une pluralité de cellules de batterie incluses dans le ou plusieurs modules de batterie (1000) ;
lorsqu'une anomalie se produit dans l'une ou plusieurs cellules de batterie parmi la pluralité de cellules de batterie, la sélection (S3300) d'un des modules de batterie, à l'exception du module de batterie incluant la cellule de batterie dans laquelle l'anomalie s'est produite, en tant que module d'alimentation ;
la transmission (S3500) d'un signal de commande à un dispositif de commande de source d'alimentation de batterie connecté à la pluralité de modules de batterie pour connecter le module d'alimentation sélectionné et le dispositif de protection de batterie (3000) ; et
la réception d'alimentation du dispositif de protection de batterie connecté au module d'alimentation et l'obtention de données d'état de la cellule de batterie dans laquelle l'anomalie s'est produite ;
**caractérisé en ce que** la sélection (S3300) d'un des modules de batterie en tant que module d'alimentation inclut :
la détermination d'un emplacement de la cellule de batterie dans laquelle l'anomalie s'est produite ; et
la sélection d'un module de batterie le plus éloigné du module de batterie incluant la cellule de batterie dans laquelle l'anomalie s'est produite, en tant que module d'alimentation.

7. Le procédé selon la revendication 6, dans lequel la sélection du module de batterie le plus éloigné du module de batterie incluant la cellule de batterie dans laquelle l'anomalie s'est produite en tant que module d'alimentation inclut, dans le cas où il existe une pluralité de modules de batterie les plus éloignés de la cellule de batterie dans laquelle l'anomalie s'est produite, la comparaison des états de charge (SOC) ou des durées de vie (état de santé, SOH) des modules de batterie pour sélectionner le module d'alimentation.

8. Le procédé selon la revendication 6, dans lequel la sélection du module de batterie le plus éloigné du module de batterie incluant la cellule de batterie dans laquelle l'anomalie s'est produite en tant que module d'alimentation inclut, dans le cas où au moins une des valeurs de SOC ou de SOH des modules de batterie est la même, la sélection d'un module de batterie connecté plus proche d'une borne négative des modules de batterie en tant que module d'alimentation.

9. Le procédé selon la revendication 6, dans lequel le dispositif de commande de source d'alimentation de batterie est configuré pour :
recevoir le signal de commande de l'appareil de gestion de batterie (7000) ; et
connecter le module d'alimentation et le dispositif de protection de batterie (3000) en fermant un commutateur correspondant au module d'alimentation sélectionné parmi une pluralité de commutateurs dans le dispositif de commande de source d'alimentation de batterie.

10. Le procédé selon la revendication 9, comprenant en outre, lorsqu'une tension de charge du module d'alimentation chute en dessous d'une valeur de seuil, la resélection d'un module de batterie ayant un taux de charge égal ou supérieur à une valeur de seuil en tant que module d'alimentation parmi les modules de batterie excluant le module de batterie incluant la cellule de batterie dans laquelle l'anomalie s'est produite.
